(19) Europäisches Patentamt
European Patent Office
Office européen des brevets

(11) Veröffentlichungsnummer : **0 331 007 B1**

(12) # EUROPÄISCHE PATENTSCHRIFT

(45) Veröffentlichungstag der Patentschrift : **02.09.92 Patentblatt 92/36**

(51) Int. Cl.$^5$ : **G03F 7/027**

(21) Anmeldenummer : **89103167.6**

(22) Anmeldetag : **23.02.89**

(54) **Lichtempfindliche Aufzeichnungsmaterialien zur Herstellung kratzfester Tiefdruckformen.**

Die Akte enthält technische Angaben, die nach dem Eingang der Anmeldung eingereicht wurden und die nicht in dieserPatentschrift enthalten sind.

(30) Priorität : **27.02.88 DE 3806270**

(43) Veröffentlichungstag der Anmeldung : **06.09.89 Patentblatt 89/36**

(45) Bekanntmachung des Hinweises auf die Patenterteilung : **02.09.92 Patentblatt 92/36**

(84) Benannte Vertragsstaaten : **AT BE CH DE ES FR GB IT LI NL SE**

(56) Entgegenhaltungen :
**CHEMICAL ABSTRACTS, Band 81, Nr. 6, 12. August 1974, Seiten 41-42, Zusammenfassung Nr. 26474e, Columbus, Ohio, US;**
**CHEMICAL ABSTRACTS, Band 104, Nr. 22, 2. Juni 1986, Seite 101, Zusammenfassung Nr. 188294s, Columbus, Ohio, US;**

(73) Patentinhaber : **BASF Aktiengesellschaft**
**Carl-Bosch-Strasse 38**
**W-6700 Ludwigshafen (DE)**

(72) Erfinder : **Raabe, Eleonore, Dr.**
**Sternstrasse 217**
**W-6700 Ludwigshafen (DE)**
Erfinder : **Beck, Erich, Dr.**
**Konrad-Adenauer-Strasse 15**
**W-6721 Harthausen (DE)**

EP 0 331 007 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft lichtempfindliche Aufzeichnungsmaterialien mit einer photopolymerisierbaren und/oder photovernetzbaren Schicht, die zur Herstellung von Tiefdruckformen mit hoher Abriebfestigkeit und ausgezeichneter Kratzfestigkeit geeignet sind.

Der Tiefdruck ist dasjenige Druckverfahren, das bei sehr hohen Auflagen ausgezeichnete Druckqualität liefert. Die Auflagen liegen, je nach Bedruckstoff, zwischen 500 000 und 5 000 000 Zylinderumdrehungen. Die Brauchbarkeit der Druckform wird durch den Abtrag der näpfchentragenden Schicht oder durch Kratzer an der Oberfläche, die sich wie Näpfchen verhalten und Farbe führen, begrenzt.

Im Tiefdruck wird heutzutage überwiegend mit Kupferzylindern gearbeitet, die mit einer dünnen Chromschicht überzogen sind. In dieser Chromschicht befinden sich die Näpfchen, die die zu übertragende Farbe aufnehmen und später an den Bedruckstoff abgeben. Die überschüssige Farbe, die sich nach dem Befüllen der Näpfchen auf der Chromoberfläche befindet, wird abgerakelt. Beim eigentlichen Druck wird die Farbe unter Verwendung eines Gegendruckzylinders auf den Bedruckstoff übertragen.

Im heute verwendeten Verfahren werden die Näpfchen durch eine Gravur in die Oberfläche des Zylinders eingebracht. Dieses Verfahren ist teuer, maschinen-investitionsintensiv und langsam. Deshalb wurde für den Tiefdruck auch die Verwendung von Kunststoffoberflächen vorgeschlagen.

So wird in DE-A 27 52 500 die Verwendung einer Tiefdruckform mit Kunststoff-Deckschicht empfohlen, die hergestellt wird, indem man den Druckformträger mit einem Kunststoff beschichtet und in der Kunststoffschicht die farbaufnehmenden Vertiefungen durch mechanisches Gravieren ausbildet. Zur Verbesserung der Graviereigenschaften kann dabei die Kunststoffschicht pulverförmige anorganische Füllstoffe einer Teilchengröße von 0.01 bis 10 μm enthalten. Zur Vermeidung von Schrammen und Riefen auf der Oberfläche dieser Tiefdruckform soll dabei anstelle der sonst üblichen Stahlrakel eine Kunststoffrakel eingesetzt werden. Die mit derart hergestellten Tiefdruckformen zu erreichenden Auflagenhöhen sind jedoch mit etwa 50 000 Zylinderumdrehungen noch nicht ausreichend hoch für einen kommerziell interessanten Einsatz. Auch ist die Herstellung der Tiefdruckformen wegen der notwendigen mechanischen Gravur der Kunststoffoberfläche nach wie vor aufwendig.

Weiterhin ist bekannt, Tiefdruckformen mit einer Kunststoff-Druckschicht unter Einsatz von photopolymerisierbaren Materialien als das die Druckschicht bildende Material herzustellen. Hierbei werden die farbaufnehmenden Vertiefungen in der Oberfläche der Druckschicht, ähnlich wie bei der Herstellung von Hochdruck und Flexodruckplatten durch bildmäßige Belichtung der photopolymerisierbaren Schicht und anschließendes Auswaschen der unbelichteten Bereiche erzeugt. Verfahren zur Herstellung von Tiefdruckformen auf Basis von photopolymerisierbaren Systemen werden u.a. in DE-A- 20 54 833, der DE-A- 20 61 287 sowie der japanischen Patentanmeldung 41 361/72 beschrieben. Derartige Tiefdruckformen basieren im allgemeinen auf gleichen oder ähnlichen photopolymerisierbaren Systemen, wie sie für die Herstellung von photopolymerisierbaren Hochdruckplatten eingesetzt werden.

Der Einsatz dieser photopolymerisierbaren Systeme erlaubt zwar die vergleichsweise schnelle, einfache und variable Herstellung von Tiefdruckformen in wirtschaftlicher Weise, doch haben sich die so hergestellten Tiefdruckformen in Praxisversuchen als nicht hinreichend abrieb- und kratzfest erwiesen. Die beim Tiefdruck üblicherweise verwendeten Stahlrakel schleifen sich nicht ohne Beschädigung der Kunststoffdruckschicht auf den in der Druckmaschine eingestellten Anstellwinkel ein. Darüber hinaus verursachen sie durch Bildung von scharfen Kanten, Löchern, Spitzen etc. häufig Kratzspuren in der Kunststoffoberfläche und bewirken einen hohen Abrieb dieser Schicht. Auch durch Einsatz von Kunststoffrakeln gemäß DE-A- 27 52 500 kommt man zu keinem wesentlich besseren Ergebnis, da die für die notwendigerweise dicken Kunststoffrakel erforderlichen erheblich höheren Anpreßdrücke zu einem starken Verschleiß führen. Daher kann auch mit diesen Tiefdruckformen nur eine Auflagenhöhe für den Tiefdruck von maximal 50 000 erreicht werden.

Es ist ebenfalls bereits bekannt, den photopolymerisierbaren Schichten von Aufzeichnungsmaterialien, die zur Herstellung von Hochdruckformen, Photoresists, Reliefbildern oder Offsetplatten geeignet sind und eingesetzt werden, feinteilige, mineralische Füllstoffe zuzusetzen. Diese Zusätze dienen entweder einfach als Füllstoffe oder werden zur Erzielung einer mattierten, aufgerauhten Oberfläche eingesetzt (vgl. u.a. DE-A- 24 03 487 und DE-A- 29 26 236). In der US-PS 3 782 939 ist erwähnt, daß positiv arbeitenden, lichtempfindlichen Elementen für die Herstellung von Photoresists anorganische Stoffe zugesetzt werden können, um die mechanischen Eigenschaften, beispielsweise auch die Abriebfestigkeit, zu verbessern. Die Oberflächenrauhigkeit spielt jedoch bei Photoresist-Materialien keine Rolle. An die Oberfläche von Tiefdruckformen werden dagegen nicht nur bezüglich ihrer Abriebfestigkeit, sondern insbesondere auch hinsichtlich ihrer Glätte, Ebenheit und Rillenfreiheit hohe Anforderungen gestellt, weshalb der Zusatz feinverteilter mineralischer Füllstoffe zu photopolymerisierbaren Aufzeichnungsmaterialien lange Zeit für die Herstellung von Tiefdruckplatten als ungeeignet und nachteilig angesehen wurde.

In EP-A- 0 070 511 wurden lichtempfindliche Aufzeichnungsmaterialien zur Herstellung von abrieb- und kratzfesten Tiefdruckformen sowie Verfahren zur Herstellung von Tiefdruckformen mittels dieser Aufzeichnungsmaterialien vorgestellt, die es erstmals ermöglichten, im Tiefdruck unter Verwendung von Zylindern mit Kunststoffoberfläche Auflagenhöhen zu erreichen, die an die heranreichen, die mit konventionellen Kupfer-Chrom-Zylindern erreichbar sind. Ermöglicht wird dies durch den Einsatz von speziellen Füllstoffen, die das photovernetzte und/oder photopolymerisierte Material abrieb- und kratzfest machen.

Im Laufe des Praxiseinsatzes hat sich gezeigt, daß die in EP-A- 0 070 511 beschriebenen Tiefdruckformen in ihrer Kratzfestigkeit doch noch verbessert werden sollten.

Aufgabe der Erfindung ist, eine Verbesserung der in EP-A- 0 070 511 beschriebenen Aufzeichnungsmaterialien zur Verwendung als Tiefdruckformen mit weiter verbesserter Kratzfestigkeit zu finden und die damit erzielbare Auflagenhöhe weiter anzuheben.

Es wurde überraschend gefunden, daß die Verwendung von bifunktionellen Acrylaten und/oder Methacrylaten aus cycloaliphatischen Epoxiden in Verbindung mit Polyvinylalkoholen oder Polyamiden zu photopolymerisierbaren und/oder photovernetzbaren Schichten führen, die nach ihrer bildmäßigen Belichtung, Auswaschen, Trocknen und Nachbelichten als Tiefdruckformen verwendbare Platten ergeben, die über eine wesentlich erhöhte Kratzfestigkeit verfügen.

Gegenstand der vorliegenden Erfindung ist ein lichtempfindliches Aufzeichnungsmaterial für die Herstellung von Tiefdruckplatten mit einer auf einem dimensionsstabilen Träger aufgebrachten 30 bis 500 μm dicken Schicht (S) eines in einer Entwicklerflüssigkeit löslichen bzw. dispergierbaren und durch Belichtung mit aktinischem Licht in dieser Entwicklerflüssigkeit unlöslich bzw. nicht mehr dispergierbar werdenden photopolymerisierbaren und/oder photovernetzbaren Materials, wobei das photopolymerisierbare und/oder photovernetzbare Material zumindest in einer Oberflächenzone von 1 bis 50 μm der Oberfläche der Schicht (S), die die spätere Oberfläche der Druckform bildet, feinteilige, abrasive Partikel in einer solchen Menge enthält, daß diese 2 bis 50 Gew.%. des diese Partikel enthaltenden photopolymerisierbaren und/oder photovernetzbaren Materials betragen, wobei die mittlere Teilchengröße der abrasiven Partikel im Bereich von 0.1 bis 6 μm liegt, höchstens 5% der abrasiven Partikel Längsausdehnungen größer 10 μm aufweisen und die abrasiven Partikel eine Härte von >4,0 auf der Mohs'schen Härteskala besitzen, die Oberfläche der Schicht (S), die die spätere Oberfläche der Druckform bildet, eine Rauhtiefe von <2 μm besitzt und die Bestandteile des photopolymerisierbaren und/oder photovernetzbaren Materials der Schicht (S) so gewählt werden, daß diese Schicht nach der Belichtung, Entwicklung und Trocknung mindestens in dem die farbaufnehmenden Vertiefungen enthaltenden Schichtdikkenbereich eine unter Last gemessene Härte von mindestens 10 N/mm2 besitzt, das dadurch gekennzeichnet ist, daß in dem photovernetzbaren und/oder photopolymerisierbaren Material mindestens ein Cyclohexandederivat gemäß der allgemeinen Formel (I)

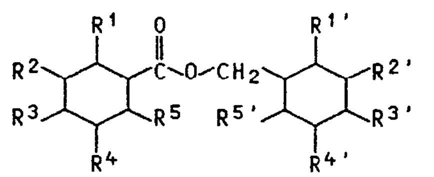

(I),

worin mindestens einer der Reste $R^1$ bis $R^5$ und $R^{1'}$ bis $R^{5'}$, jedoch nicht mehr als zwei der Reste $R^1$ bis $R^5$ und nicht mehr als zwei der Reste $R^{1'}$ bis $R^{5'}$ für die Gruppierung -O-C(O)-$CR^6$=$CH_2$ mit $R^6$=H oder $CH_3$ stehen, mindestens einer der Reste $R^1$ bis $R^5$ und $R^{1'}$ bis $R^{5'}$, jedoch nicht mehr als zwei der Reste $R^1$ bis $R^5$ und nicht mehr als zwei der Reste $R^{1'}$ bis $R^{5'}$ für OH-Gruppen stehen und die noch verbleibenden Reste $R^1$ bis $R^5$ und $R^{1'}$ bis $R^{5'}$ für H oder $CH_3$ stehen, enthalten ist.

Unter die allgemeine Formel (I) fallende Verbindungen sind bereits aus JP-A-7388126 bekannt.

Erfindungsgemäß vorteilhaft einzusetzen sind Mono-, Di-, Tri- und Tetraacrylate und entsprechende -methacrylate gemäß Formel (I).

Bevorzugt sind solche Aufzeichnungsmaterialien, die Verbindungen der Formel (I) enthalten, worin Hydroxylgruppe und

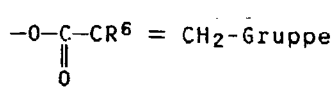

jeweils an benachbarten Kohlenstoffatomen stehen, sowie solche, in denen jeweils einer der OH- oder -O-

$C(O)-CR^6=CH_2$-Reste in para-Stellung zu dem C-Atom des Cyclohexanrings steht, über das die beiden Cyclohexanringe über die $-CO-O-CH_2$-Gruppe miteinander verbunden sind.

Besonders bevorzugt als Verbindung der allgemeinen Formel (I) sind Umsetzungsprodukte des 3,4-Epoxycyclohexylmethyl-3′,4′-epoxycyclohexancarboxylats mit Acrylsäure oder Methacrylsäure im molaren Verhältnis von 1:1 bis 1:2,5, insbesondere 1:2 bis 1:2,2.

In den erfindungsgemäßen Aufzeichnungsmaterialien können auch bis zu 60, insbesondere 30 bis 50 Gew.% der Verbindungen der allgemeinen Formel (I) durch eine oder mehrere weitere photopolymerisierbare und/oder photovernetzbare Verbindungen ersetzt sein.

Besonders vorteilhaft sind solche erfindungsgemäßen Aufzeichnungsmaterialien, die als photopolymerisierbares und/oder photovernetzbares Material ein Gemisch mindestens einer Verbindung der allgemeinen Formel (I) mit einem teilverseiften Polyvinylacetat, dessen Hydroxylgruppen teilweise mit Acrylsäure oder Methacrylsäure verestert ist, enthalten.

Gegenstand der Erfindung ist auch ein Verfahren zur Herstellung von Tiefdruckformen durch Belichten eines lichtempfindlichen Aufzeichnungsmaterials mit einer photopolymerisierbaren und/oder photovernetzbaren Schicht (S) auf einem dimensionsstabilen Träger mit aktinischem Licht durch ein Raster- oder Strich-Positiv oder durch ein Halbton-Positiv und eine Führungsraster-Vorlage, anschließendes Auswaschen der nicht belichteten Anteile der Schicht (S) mit Hilfe einer Entwicklerflüssigkeit, in der die nicht belichteten Anteile, nicht aber die belichteten Anteile der Schicht (S) löslich oder dispergierbar sind, sowie Trocknen und gegebenenfalls Nachbehandlung der erhaltenen Tiefdruckform, wobei man zur Herstellung der Tiefdruckformen ein lichtempfindliches Aufzeichnungsmaterial gemäß vorliegender Erfindung einsetzt.

Dabei kann es besonders vorteilhaft sein, die Tiefdruckformen nach dem Auswaschen und Trocknen vollflächig mit aktinischem Licht nachzubelichten, bzw. bei einer Temperatur im Bereich von 200 bis 260°C nachzuhärten.

Es lassen sich somit erfindungsgemäß einfach, schnell und wirtschaftlich Tiefdruckformen herstellen, die in ihrer Qualität weitgehend den konventionellen Tiefdruckformen mit verchromten Kupferzylindern entsprechen.

Unter Tiefdruckformen werden Druckplatten, Druckfolien oder Druckzylinder verstanden, die die farbführenden Bildteile für den Druck als Vertiefungen in der Oberfläche enthalten. Bei den erfindungsgemäßen Tiefdruckformen befinden sich diese farbaufnehmenden Vertiefungen in der photopolymeren Schicht, wobei diese photopolymere Druckschicht haftfest auf einen üblicherweise aus Metall hergestellten Druckformträger, beispielsweise eine Stahlplatte oder einen Stahlzylinder, aufgebracht ist. Die Dicke der photopolymeren Kunststoff-Druckschicht und somit auch die Dicke der photopolymerisierbaren und/oder photovernetzbaren Schicht (S) der lichtempfindlichen Aufzeichnungsmaterialien liegt im allgemeinen im Bereich von 30 bis 500 $\mu m$, vorzugsweise im Bereich von 50 bis 250 $\mu m$. Die Tiefe der Näpfchen, d.h. der farbaufnehmenden Vertiefungen, beträgt im Normalfall einige wenige $\mu m$, z.B. 2 bis 3 $\mu m$, für die Näpfchen mit der geringsten Tiefe und reicht bis zu Werten von etwa 10 bis 100 $\mu m$, vorzugsweise von etwa 20 bis 60 $\mu m$, für die tiefsten Näpfchen.

Als in einer Entwicklerflüssigkeit lösliches bzw. dispergierbares und durch Belichtung mit aktinischem Licht darin unlöslich bzw. nicht mehr dispergierbar werdendes photoempfindliches Material für die Schicht (S) der lichtempfindlichen Aufzeichnungsmaterialien kommen die an sich bekannten photopolymerisierbaren und/oder photovernetzbaren Systeme auf Basis von Verbindungen mit mindestens einer photopolymerisierbaren oder photovernetzbaren Doppelbindung in Frage, die erfindungsgemäß mindestens eine Verbindung der allgemeinen Formel (I) enthalten. Das Unlöslichwerden dieser Materialien in den Entwicklerflüssigkeiten beruht auf einer strahlungsinitiierten Polymerisation bzw. Vernetzung der ungesättigten Verbindungen.

Zu den photopolymerisierbaren und/oder photovernetzbaren Materialien, die für den Zweck der Erfindung in Betracht kommen, gehören z.B. Photopolymerisationsinitiatoren enthaltende Gemische mit einer oder mehreren Verbindungen der allgemeinen Formel (I) sowie gegebenenfalls weiteren photopolymerisierbaren, olefinisch ungesättigten, niedermolekularen Verbindungen als einem Mischungsbestandteil. Ebenso können Polymere, die einen hinreichenden Anteil an photopolymerisierbaren, olefinischen Doppelbindungen eingebaut enthalten, zusammen mit Verbindungen der Formel (I) und mindestens einem Photopolymerisationsinitiator eingesetzt werden. Vorzugsweise besteht das photopolymerisierbare und/oder photovernetzbare Material der Schicht (S) der lichtempfindlichen Aufzeichnungsmaterialien im wesentlichen aus mindestens einem gesättigten und/oder ungesättigten Polymeren, mindestens einer photopolymerisierbaren, olefinisch ungesättigten, niedermolekularen Verbindung der allgemeinen Formel (I), mindestens einem Photopolymerisationsinitiator sowie gegebenenfalls weiteren Zusatzstoffen und/oder Hilfsmitteln.

Als Polymere, im allgemeinen das Basismaterial, für die photopolymerisierbaren und/oder photovernetzbaren Materialien sind die in Entwicklerlösungsmitteln löslichen synthetischen Polymeren geeignet, die zur Herstellung von photopolymerisierbaren Schichten, insbesondere die Herstellung von Reliefformen für Druckzwecke bekannt und üblich sind. Beispielhaft seien genannt Vinylpolymerisate, wie Polyvinylchlorid, Vinylidenchloridpolymerisate, Copolymere aus Vinylchlorid und Vinylestern von Monocarbonsäuren mit 2 bis 11 Kohlenstoffatomen und gegebenenfalls Vinylalkohol; Polymere aus überwiegenden Mengen von olefinisch ungesättigten Carbonsäuren mit 3 bis 5 Kohlenstoffatomen und/oder deren Ester und/oder deren Amide, z.B. Polymerisate von Acrylsäure, Methacrylsäure, Acrylamid, Methacrylamid, Acrylaten oder Methacrylaten von Alkanolen mit 1 bis 12 Kohlenstoffatomen oder aliphatischen Diolen und Polyolen, wie Ethylenglykol, 1,4-Butandiol oder Glycerin. Ferner geeignet sind Polymere auf der Basis von Styrol oder Vinylestern von Monocarbonsäuren mit 2 bis 11 Kohlenstoffatomen, wie Vinylacetat und Vinylchloracetat; Polyformaldehyd; Polyimide und Polyamidimide; Polyurethane, Polyetherurethane, Polyesterurethane, vorzugsweise mit eingebauten Harnstoffgruppierungen; Melaminformaldehyd- oder Phenolformaldehyd-Harze; sowie im besonderen die üblichen ungesättigten Polyesterharze aus mehrwertigen, insbesondere zweiwertigen Carbonsäuren und mehrwertigen, insbesondere zweiwertigen Alkoholen. Als ungesättigte Polyester kommen beispielsweise solche in Betracht, deren Säurekomponente sich von Maleinsäure, Fumarsäure, Itaconsäure, Citraconsäure oder Mesaconsäure neben anderen ungesättigten und/oder gesättigten mehrwertigen Carbonsäuren ableitet und deren Alkoholkomponente beispielsweise von Alkandiolen, wie Ethylenglykol, 1,2- oder 1,3-Propandiol, Butylenglykol-1,3, Butandiol-1,4, Hexandiol-1,6, Diethylenglykol, Triethylenglykol, Tetraethylenglykol oder Neopentylglykol herrührt.

Als vorteilhafte Basiskomponente für die photopolymerisierbaren und/oder photovernetzbaren Materialien haben sich insbesondere Vinylalkohol-Polymere mit $CH_2CH(OH)$-Struktureinheiten in der Polymerhauptkette erwiesen sowie deren in Wasser oder wäßrigen Entwicklerflüssigkeiten lösliche oder dispergierbare Copolymerisate und Derivate, wie Ester, Ether oder Acetale. Besonders geeignet sind die bekannten verseiften Polyvinylester von aliphatischen Monocarbonsäuren mit 1 bis 4 C-Atomen, wie Polyvinylacetate oder Polyvinylpropionate, deren mittlerer Polymerisationsgrad 200 bis 3 000 und insbesondere 250 bis 750, und deren Verseifungsgrad 65 bis etwa 100 und insbesondere 80 bis 88 Mol.% beträgt. Auch Gemische von verseiften Vinylester-Polymeren oder -Copolymeren mit unterschiedlichem Polymerisationsgrad und/oder unterschiedlichem Verseifungsgrad können angewandt werden. Desweiteren seien in diesem Zusammenhang insbesondere die Umsetzungsprodukte von Vinylalkohol-Polymeren mit Acryl- und/oder Methacrylsäureanhydrid erwähnt, wobei diese Umsetzungsprodukte im allgemeinen 3 bis 30 Gew.%, bezogen auf das Umsetzungsprodukt, an Acryloyl- oder Methacryloyl-Gruppen eingebaut enthalten, als auch die wasserlöslichen Umsetzungsprodukte von Vinylalkohol-Polymeren mit Ethylenoxid, wobei der Anteil der Ethylenoxid-Einheiten im oxethylierten Vinylalkohol-Polymer 5 bis 75 Gew.%, insbesondere 10 bis 60 Gew.%, beträgt. Diese Umsetzungsprodukte von Vinylalkohol-Polymeren können als alleinige Polymer-Komponente in den photopolymerisierbaren und/oder photovernetzbaren Materialien enthalten sein; sie können aber auch in Mischung mit anderen Vinylalkohol-Polymeren, insbesondere den erwähnten verseiften Polyvinylestern vorliegen, wobei dann der Anteil der Umsetzungsprodukte des Polyvinylalkohols vorteilhaft mindestens 30 Gew.%, bezogen auf die gesamten in der Mischung enthaltenen Vinylalkohol-Polymeren, beträgt. Darüber hinaus ist es möglich, daß die genannten Vinylalkohol-Polymeren oder -Copolymeren und/oder deren Derivate mit bis zu etwa 30 Gew.%, bezogen auf den Polymeranteil des jeweiligen photopolymerisierbaren und/oder photovernetzbaren Materials, an verträglichen Melamin-Formaldehyd-Harzen, Harnstoff-Formaldehyd-Harzen oder Phenol-Formaldehyd-Harzen abgemischt sind.

Besonders geeignete Polymere für die photopolymerisierbaren und/oder photovernetzbaren Materialien sind auch die in üblichen organischen und insbesondere alkoholischen Lösungsmitteln (als Entwicklerflüssigkeit) löslichen linearen synthetischen Polyamide mit wiederkehrenden Amidgruppen in der Molekülhauptkette. Von ihnen werden die Mischpolymerisate bevorzugt, die in üblichen Lösungsmitteln oder Lösungsmittelgemischen, insbesondere in niederen aliphatischen Alkoholen, wie z.B. Ethanol oder n-Propanol, oder Gemischen von diesen Alkoholen mit Wasser löslich sind. Dies sind z.B. Mischpolyamide, die in üblicher Weise durch Polykondensation oder Polymerisation aus zwei oder mehreren Lactamen mit 5 bis 13 Ringgliedern hergestellt worden sind. Solche Lactame sind beispielsweise Pyrrolidon, Caprolactam, Önantholactam, Capryllactam, Laurinlactam bzw. entsprechende C-substituierte Lactame, wie ε-Methyl-ε-caprolactam, ε-Ethyl-ε-caprolactam oder δ-Ethylönantholactam. Anstelle der Lactame können die ihnen zugrundeliegenden Aminocarbonsäuren polykondensiert worden sein. Weitere geeignete Mischpolyamide sind Polykondensationsprodukte aus Salzen vom Typ Diamin/Dicarbonsäure, die aus mindestens 3 polyamidbildenden Ausgangsstoffen hergestellt worden sind. Hierfür geeignete Dicarbonsäuren bzw. Diamine sind bevorzugt aliphatische Dicarbonsäuren mit 4 bis 20 Kohlenstoffatomen, wie Adipinsäure, Korksäure, Sebacinsäure, Dodecandicarbonsäure sowie entsprechende Substitutionsprodukte, wie α,α-Diethyladipinsäure, α-Ethylkorksäure, Heptadecandicarbonsäure-1,8 oder Heptadecandicarbonsäure-1,9 bzw. deren Gemische sowie aliphatische oder aromatische Ringsysteme enthaltende Dicarbonsäuren. Geeignete Diamine sind insbesondere aliphatische oder cycloaliphatische Diamine mit 2 primären und/oder sekundären Aminogruppen, insbesondere mit 4 bis 20 Kohlenstoffatomen, wie Pentamethylendiamin, Hexamethylendiamin, Heptamethylendiamin, Octamethylendiamin oder C- und/oder N-substituierte Derivate dieser Amine, wie N-Methyl-N′-ethyl-hexamethylendiamin, 1,6-Diamino-4-methylhexan, 4,4′-Diaminodicyclohexylmethan oder 2,2-(4,4′-Diaminodicyclohexyl)-propan, ferner aromatische Diamine, wie m-Phenylendiamin, m-Xylylendiamin oder 4,4′-Diaminodiphenylmethan, wobei bei allen Ausgangsstoffen die Brückenglieder zwischen den beiden Carbonsäuregruppen bzw. Aminogruppen auch durch Heteroatome, z.B. Sauerstoff-, Stickstoff- oder Schwefelatome unterbrochen sein können. Besonders geeignete Mischpolyamide sind solche, die durch Mischkondensation eines Gemisches aus einem oder mehreren Lactamen, insbesondere Caprolactam und mindestens einem Dicarbonsäure/Diamin-Salz hergestellt worden sind, z.B. aus ε-Caprolactam, Hexamethylendiammonium-Adipat und 4,4′-Diaminodicyclohexylmethan/Adipinsäure-Salz.

Das lichtempfindliche Aufzeichnungsmaterial enthält im photopolymerisierbaren und/oder photovernetzbaren Material erfindungsgemäß mindestens ein Cyclohexanderivat der allgemeinen Formel (I), wobei solche Verbindungen gemäß Formel (I) bevorzugt sind, in denen die OH- und -O-C(0)-$CR^6$=$CH_2$ Gruppe an benachbarten Kohlenstoffatomen und in para-Stellung zu dem C-Atom des Cyclohexanrings steht, über das die beiden Cyclohexanringe über die -CO-O-$CH_2$-Gruppe miteinander verbunden sind, z.B. das Umsetzungsprodukt des 3,4-Epoxycyclohexylmethyl-3′,4′-epoxycyclohexancarboxylats mit Acrylsäure oder Methacrylsäure in Mengen von mindestens 10 Gew.%, maximal 50 Gew.%, besonders bevorzugt 20-45 Gew.%, jeweils bezogen auf die Gesamtmenge des lichtempfindlichen Aufzeichnungsmaterials.

Als gegebenenfalls mitzuverwendende photopolymerisierbare, olefinisch ungesättigte niedermolekulare Verbindungen kommen die bekannten Monomeren und Oligomeren mit einem Molekulargewicht unter 2 000 in Frage, die für polymere Bindemittel enthaltende photopolymerisierbare und/oder photovernetzbare Materialien an sich bekannt sind, wobei sich natürlich Art und Menge der photopolymerisierbaren niedermolekularen Verbindungen nach dem mitverwendeten polymeren Bindemittel richten, mit dem sie verträglich sein sollen. Bevorzugt sind photopolymerisierbare niedermolekulare Verbindungen mit 2 oder mehr ethylenisch ungesättigten photopolymerisierbaren Doppelbindungen allein oder deren Mischungen mit Monomeren mit nur einer olefinisch ungesättigten photopolymerisierbaren Doppelbindung, wobei der Anteil der Monomeren mit nur einer Doppelbindung im allgemeinen etwa 5 bis 50 Gew.% und bevorzugt 5 bis 30 Gew.% der Gesamtmonomermenge betragen kann. Es ist unter bestimmten Voraussetzungen selbstverständlich auch möglich, daß als gegebenenfalls mitzuverwendende photopolymerisierbare niedermolekulare Verbindungen überwiegend oder nur solche eingesetzt werden, die nur eine photopolymerisierbare Doppelbindung im Molekül enthalten, insbesondere dann, wenn das in den photopolymerisierbaren und/oder photovernetzbaren Materialien enthaltene Polymer selber einen hohen Anteil an photopolymerisierbaren Doppelbindungen enthält, wie z.B. im Fall der acryloierten und/oder methacryloierten Vinylalkohol-Polymerisate. Im allgemeinen haben die photopolymerisierbaren niedermolekularen Verbindungen einen Siedepunkt von über 100°C bei Atmosphärendruck.

Als Beispiele für gegebenenfalls mitzuverwendende photopolymerisierbare olefinisch ungesättigte niedermolekulare Verbindungen seien genannt: Mono-, Di- und Polyacrylate und -methacrylate, wie sie durch Veresterung von Acrylsäure oder Methacrylsäure mit ein- oder mehrwertigen niedermolekularen Alkoholen hergestellt werden können. Hierzu gehören u.a. die Di- und Tri(meth)acrylate von Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, Neopentylglykol (2,2-Dimethylpropandiol), 1,4-Butandiol, 1,1,1-Trimethylolpropan, Glycerin oder Pentaerythrit; ferner die Monoacrylate und Monomethacrylate solcher Diole oder Polyole, wie z.B. Ethylenglykol-mono-(meth)acrylat, 1,2-Propandiol-mono-(meth)acrylat, 1,3-Propandiol-mono-(meth)-acrylat und das Di-, Tri- oder Tetraethylenglykol-mono-(meth)-acrylat. Weiterhin kommen photopolymerisierbare, olefinisch ungesättigte niedermolekulare Verbindungen in Betracht, die Urethangruppen und/oder Amidgruppen enthalten, wie die aus aliphatischen Diolen der vorstehend genannten Art, organischen Diisocyanaten, wie z.B. Hexamethylendiisocyanat, Toluylendiisocyanat und Isophorondiisocyanat, und Hydroxyalkyl-(meth)acrylaten der oben genannten Art hergestellten niedermolekularen Verbindungen. Genannt seien ferner auch Acrylsäure, Methacrylsäure, (Meth)acrylate von Monoalkanolen mit 1 bis 6 C-Atomen, Mono- und Bis-(meth)-acrylamide von aliphatischen oder aromatischen Diaminen mit 2 bis 8 C-Atomen, wie von Ethylendiamin, Propylendiamin, Butylendiamin, Pentamethylendiamin, Hexamethylendiamin, Octamethylendiamin oder Xylylendiamin, als auch Derivate der (Meth)acrylamide, z.B. N-Hydroxymethyl-(meth)acrylamid, oder die Umsetzungsprodukte von N-Hydroxymethyl-(meth)acrylamid mit einem aliphatischen Diol, z.B. Ethylenglykol oder Propylenglykol.

Die photopolymerisierbaren und/oder photovernetzbaren Materialien enthalten die Polymeren und die photopolymerisierbaren olefinisch ungesättigten niedermolekularen Verbindungen im allgemeinen in einer Menge von etwa 50 bis 90 Gew.% bzw. von 10 bis 50 Gew.%, jeweils bezogen auf die Summe von Polymer und photopolymerisierbarer, niedermolekularer Verbindung. Der Anteil der photopolymerisierbaren niedermolekularen Verbindungen kann in einzelnen Fällen auch größer oder kleiner sein.

Als Photopolymerisationsinitiatoren, die in den photopolymerisierbaren und/oder photovernetzbaren Materialien im allgemeinen in Mengen von 0,05 bis 10 Gew.% und insbesondere von 0,5 bis 5 Gew.%, bezogen auf das gesamte photopolymerisierbare und/oder photovernetzbare Material, enthalten sind, kommen die bekannten und üblichen Photopolymerisationsinitiatoren und Systeme für die Auslösung einer Photopolymerisation bei Bestrahlung mit aktinischem Licht in Frage, wie sie hinreichend in der einschlägigen Fachliteratur beschrieben sind. Genannt seien z.B. Acyloine und deren Derivate, wie Benzoin, Benzoinalkylether, z.B. Benzoinmethylether oder Benzoinisopropylether, $\alpha$-Methylolbenzoin und dessen Ether oder $\alpha$-Methylbenzoin und dessen Ether; 1,2-Diketone und deren Derivate wie Diacetyl, Benzil, Benzilketale wie Benzildimethylketal, Benzilmethylethylketal, Benzilmethylbenzylketal oder Benzilethylenglykol-monoketal; Acylphosphinoxid-Verbindungen, insbesondere Acyl-Diarylphosphinoxide und speziell Acyl-Diphenylphosphinoxide, deren Acylrest sich von einer tertiären aliphatischen oder cycloaliphatischen Carbonsäure oder von einer mindestens in 2,6-Stellung substituierten Benzoesäure ableitet, wie sie in der DE-A 29 09 992 ausführlich beschrieben sind.

Die Photopolymerisationsinitiatoren können allein oder in Mischung miteinander oder auch in Mischung mit Aktivatoren, wie z.B. tertiären Aminen, eingesetzt werden. Vorteilhafterweise werden möglichst aktive Photopolymerisationsinitiatoren verwendet. Überraschenderweise wurde gefunden, daß Tiefdruckformen mit besonders glatter Oberfläche dann erhalten werden, wenn in den photopolymerisierbaren und/oder photovernetzbaren Materialien neben Photoinitiatoren, die im aktinischen Wellenlängenbereich, insbesondere von 300 bis 380 nm, niedrig absorbierend sind, wie z.B. die genannten Benzoine, Benzoinether, Benzil oder Benzilmonoketale, zusätzlich solche Photoinitiatoren enthalten sind, deren Extinktionskoeffizienten $\varepsilon$ bei 360 nm >500 $cm^2$/mMol, insbesondere >5 000 $cm^2$/mMol sind. Als Beispiele für solche stark absorbierenden Coinitiatoren seien genannt das 4,4′-Bis(N-dimethylamino)benzophenon (Michlers Keton) sowie Derivate von Michlers Keton, beispielsweise die in der EP-A1-0 000 342 beschriebenen 4,4′-Bis(N-hydroxyalkyl-N-alkylamino)benzophenone, wie das 4,4′-Bis(N-$\beta$-hydroxyethyl-N-methylamino)benzophenon, das 4,4′-Bis(N-$\beta$-N-ethyl-amino)benzophenon, das 4,4′-Bis(N-$\beta$-hydroxyethyl-N-propyl-amino)benzophenon, das 4,4′-Bis(N-$\beta$-hydroxypropyl-N-methyl-amino)benzophenon, das 4,4′-Bis(N-hydroxypropyl-N-ethyl-amino)benzophenon. Für die vorteilhafte Initiatorkombination von stark absorbierenden und niedrig absorbierenden Initiatoren können die für Michlers Keton bekannten molaren Verhältnisse und Mengen angewandt werden. Üblicherweise sind die stark absorbierenden Initiatoren in den photopolymerisierbaren und/oder photovernetzbaren Materialien - je nach Dicke der diese Initiatoren enthaltenden Schicht -in Mengen von etwa 0,05 bis 0,4 Gew.%, vorzugsweise von 0,1 bis 0,25 Gew.% enthalten, wobei sich das Verhältnis von stark absorbierendem Initiator zu niedrig absorbierendem Coinitiator nach den angestrebten Belichtungseigenschaften richtet und beispielsweise 1:10 betragen kann.

Es ist oft zweckmäßig, den photopolymerisierbaren und/oder photovernetzbaren Materialien andere übliche Hilfsstoffe und Zusätze zuzugeben. Hierzu gehören insbesondere die Inhibitoren gegen die thermische Polymerisation, wie Hydrochinon, p-Methoxyphenol, m-Dinitrobenzol, p-Chinon, Methylenblau, $\beta$-Naphthol, N-Nitrosamine, wie N-Nitrosodiphenylenamin oder die Salze, insbesondere die Alkali- und Aluminiumsalze des N-Nitroso-cyclohexyl-hydroxylamins. Diese Inhibitoren werden im allgemeinen in Mengen von 0,01 bis 2,0 Gew.%, bezogen auf das gesamte photopolymerisierbare und/oder photovernetzbare Material, verwendet. Diese Materialien können darüber hinaus als weitere Zusätze beispielsweise Weichmacher, Farbstoffe, Pigmente oder dergleichen enthalten.

Gemäß einer besonders vorteilhaften Ausführungsform der vorliegenden Erfindung kann die photopolymerisierbare Schicht noch ein Reglersystem enthalten, wie es beispielsweise in EP-A- 114 341 beschrieben ist.

Dies sind Mischungen bestimmter Farbstoffe (1) mit milden Reduktionsmitteln (2) für den mitverwendeten jeweiligen Farbstoff (1) (vgl. auch EP-A- 0 114 341). Die Mischung (1) + (2) soll bei der bildmäßigen Belichtung mit aktinischem Licht keine merkliche Photopolymerisation in der Schicht der photopolymerisierbaren Mischung auslösen, was mit wenigen Versuchen feststellbar ist. Beträgt z.B. die Belichtungszeit für erfindungsgemäße, bevorzugt im wesentlichen lösungsmittelfreie Schichten der photopolymerisierbaren, den Photoinitiator enthaltenden Mischung X Stunden oder Minuten, so sollte die entsprechende Schicht, die den Photoinitiator nicht enthält, mit Vorteil auch bei Anwendung der zehnfachen Belichtungszeit beim anschließenden Entwickeln der Reliefform durch Auswaschen keine merklichen Anteile an photopolymerisierter Schicht aufweisen, im allgemeinen sollten weniger als 20 Gew.% der belichteten Monomermengen photopolymerisiert sein.

Als Farbstoffe (1) für die photopolymerisierbaren Mischungen eignen sich vor allem solche aus der Reihe der Phenoxazinfarbstoffe, wie z.B. Capriblau GN (C.I. 51000), Zaponechtblau 3 G (C.I. 51005), Galloblau E (C.I. 51040), Echtneublau 3 (C.I. 51175), Nilblau A (C.I. 51180), Echtgrün M (C.I. 51210), Echtschwarz L (C.I. 51215), sowie Rhodanilblau, dem Salz bzw. Amid aus Rhodamin B (Basic Violet 10, C.I. 45170) und Nilblau (Basic Blue 12, C.I. 51180), Verbindungen aus der Reihe der Phenaziniumfarbstoffe, wie z.B. Neutralrot (C.I. 50040), Neutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Idaminblau B (C.I. 50204), Rhodulinrot G (C.I. 50215), Rhodulinblau GG extra (C.I. 50220), Indazin GB (C.I. 50221), Safranin T (C.I. 50240), Mauvein (C.I. 50245), Naphthylrot (C.I. 50370) sowie Nigroinschwarz T (C.I. 50415), Acriflavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075), ferner Phenothiaziniumfarbstoffe, wie z.B. Methylenblau oder Thionin. Ebenso eignet sich (Isobutylthio)anthrachinon als Farbstoff (1).

Die Auswahl des in der photopolymerisierbaren Mischung verwendeten Farbstoffs (1) wird vor allem vom ästhetischen Eindruck mitbestimmt. So ist z.B. eine visuelle Beurteilung der Druckplatten besonders einfach mit den Verbindungen Neutralrot (C.I. 50040), Safranin T (C.I. 50240) sowie Rhodanilblau, die bevorzugt in der photopolymerisierbaren Mischung verwendet werden.

Die erfindungsgemäßen Schichten enthalten in Kombination mit dem Farbstoff (1) eine für diesen hinreichende Menge eines Reduktionsmittels (2) für den Farbstoff (1), das den mitverwendeten Farbstoff (1) in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionssmittel sind Ascorbinsäure, Anethol, Thioharnstoff, Diethylallylthioharnstoff, Hydroxylamin-derivate, insbesondere N-Allylthioharnstoff und bevorzugt Salze des N-Nitrosocyclohexyl-hydroxylamins, insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel beträgt im allgemeinen etwa 0,005 bis 5 und insbesondere 0,01 bis 1 Gew.%, bezogen auf die Gesamtmenge der photopolymerisierbaren Schicht, soll jedoch nicht weniger als das Reduktionsäquivalent der Menge des verwendeten Farbstoffs (1) betragen. In vielen Fällen hat sich der Zusatz des 3- bis 10-fachen der Menge an mitverwendetem Farbstoff (1) bewährt.

Das lichtempfindliche Aufzeichnungsmaterial enthält für die Herstellung der Tiefdruckformen in der photopolymerisierbaren und/oder photovernetzbaren Schicht (S) feinteilige, harte, abrasive Partikel. Die mittlere Teilchengröße der abrasiven Partikel soll im Bereich von 0,1 bis 6 µm liegen, wobei höchstens 5%, vorzugsweise weniger als 1% der abrasiven Partikel Längsausdehnungen größer 10 µm haben dürfen. Die mittlere Teilchengröße der abrasiven Partikel kann nach den bekannten Methoden, insbesondere der Sedimentationsanalyse, ermittelt werden. Unter Längsausdehnung der Partikel wird der projezierte Abstand zwischen zwei Punkten der Partikeloberfläche verstanden. Die Längsausdehnungen der Teilchen können z.B. nach den üblichen mikroskopischen Meßmethoden bestimmt werden.

Die Härte der abrasiven Partikel soll >4,0 auf der Mohs'schen Härteskala betragen. Vorteilhaft liegt die Härte der abrasiven Partikel bei 6 oder mehr der Mohs'schen Härteskala. Bei den abrasiven Partikeln, die für den Zweck der Erfindung in Betracht kommen, handelt es sich insbesondere um mineralische Füllstoffe und Pigmente, wie z.B. Siliciumdioxid, insbesondere Quarzmehl und Cristobalit; Silikate, insbesondere Aluminiumsilikate, Silikatgläser; Aluminiumoxide, insbesondere Korund; Titandioxid, Siliciumcarbid, Wolframcarbid u.a.. Die feinteiligen, abrasiven Partikel können dabei in an sich bekannter Weise auch oberflächlich behandelt oder beschichtet sein, um beispielsweise die Dispergierbarkeit und/oder die Haftung in der photopolymerisierbaren und/oder photovernetzbaren Schicht (S) zu verbessern.

Vorteilhafterweise werden solche abrasiven Partikel verwendet, die für aktinisches Licht weitgehend durchlässig sind, wobei es desweiteren von Vorteil ist, wenn die Brechungsindices der abrasiven Partikel und des für die Schicht (S) eingesetzten photopolymerisierbaren und/oder photovernetzbaren Materials aneinander angeglichen worden sind. Für diesen Fall hat sich der Einsatz von Siliciumdioxid, besonders Quarzmehl und Cristobalit, als abrasive Partikel als sehr günstig erwiesen.

Die abrasiven Partikel können in der gesamten photopolymerisierbaren und/oder photovernetzbaren Schicht (S) enthalten und in dieser gleichmäßig verteilt sein.

In den Fällen, in denen die abrasiven Partikel nur in einer Oberflächenzone der photopolymerisierbaren und/oder photovernetzbaren Schicht (S) von 1 bis 50 µm, vorzugsweise 5 bis 20 µm Dicke enthalten sind, können ohne wesentliche Beeinträchtigung der Belichtungseigenschaften der lichtempfindlichen Aufzeichnungsmaterialien lichtstreuende abrasive Partikel eingesetzt werden, d.h. die Brechungsindices der abrasiven Partikel und des die abrasiven Partikel enthaltenden photopolymerisierbaren und/oder photovernetzbaren Materials können verschieden sein. Die feinteiligen, abrasiven Partikel können hierbei für aktinisches Licht durchlässig, also nicht absorbierend sein, sie können das aktinische Licht aber auch absorbieren. Sind in den photopolymerisierbaren und/oder photovernetzbaren Materialien feinteilige abrasive Partikel enthalten, die für aktinisches Licht nicht durchlässig sind, d.h. dieses stark absorbieren, so sind diese abrasiven Partikel auch dann vorteilhafterweise nur in einer Oberflächenzone von 1 bis 50 µm, vorzugsweise 5 bis 20 µm Dicke der Schicht (S) enthalten, wenn die Brechungsindices der abrasiven Partikel und des diese Partikel enthaltenden photopolymerisierbaren und/oder photovernetzbaren Materials aneinander angeglichen sind. Werden lichtstreuende und/oder -absorbierende abrasive Partikel eingesetzt, so ist es sinnvoll und günstig, wenn die Dicke der die abrasiven Partikel enthaltenden Oberflächenzone dem Maß der Lichtstreuung und -absorption angepaßt wird.

Die abrasiven Partikel liegen in der photopolymerisierbaren und/oder photovernetzbaren Schicht (S) in einer Menge von 2 bis 50 Gew.%, vorzugsweise von 5 bis 30 Gew.% vor, bezogen auf den Teil der Schicht (S), der die abrasiven Partikel enthält, d.h. in dem Fall, in dem die gesamte Schicht (S) die abrasiven Partikel enthält, sind die Angaben auf das gesamte photopolymerisierbare und/oder photovernetzbare Material bezogen, und in dem Fall, in dem die abrasiven Partikel nur in einer Oberflächenzone der Schicht (S) enthalten sind, sind diese Angaben auf den Teil des photopolymerisierbaren und/oder photovernetzbaren Materials bezogen, der diese die abrasiven Partikel enthaltende Oberflächenzone darstellt. Geeignete abrasive Partikel enthaltende photopolymerisierbare und/oder photovernetzbare Materialien bestehen somit im allgemeinen im wesentlichen aus 30 bis 90 Gew.% an Polymeren als Basismaterial, 10 bis 50 Gew.% an photopolymerisierbaren, olefinisch ungesättigten, niedermolekularen Verbindungen, 0,05 bis 10 Gew.% , insbesondere 0,2 bis 5 Gew.% an Photopolymerisationsinitiatoren, 2 bis 50 Gew.%, vorzugsweise 5 bis 30 Gew.% an abrasiven Partikeln sowie gegebenenfalls aus weiteren üblichen Hilfs- und Zusatzstoffen in üblichen und bekannten Mengen, wobei sich die angegebenenen Gewichtsprozente jeweils auf das die abrasiven Partikel enthaltende photopolymerisierbare und/oder photovernetzbare Material beziehen.

In dem Fall, in dem die photopolymerisierbare und/oder photovernetzbare Schicht (S) der lichtempfindlichen Aufzeichnungsmaterialien die abrasiven Partikel nur in einer dünnen Oberflächenzone enthält, wohingegen der übrige Teil der photopolymerisierbaren und/oder photovernetzbaren Schicht (S) keine abrasiven Partikel enthält, die photopolymerisierbare und/oder photovernetzbare Schicht (S) somit aus mehreren Lagen besteht, ist es möglich, daß die einzelnen Lagen der photopolymerisierbaren und/oder photovernetzbaren Schicht (S) mit Ausnahme der abrasiven Partikel aus den sonst gleichen photopolymerisierbaren und/oder photovernetzbaren Materialien bestehen. Es ist aber ebenso möglich, daß sich die photopolymerisierbaren und/oder photovernetzbaren Materialien dieser Lagen auch bezüglich der anderen Bestandteile, wie z.B. Art und Menge des Basispolymeren, Art und Menge der photopolymerisierbaren olefinisch ungesättigten niedermolekularen Verbindungen oder Art und Menge der Photopolymerisationsinitiatoren unterscheiden. So ist es beispielsweise besonders günstig, wenn eine mehrlagige Schicht (S), in der die abrasiven Partikel enthaltenden Lage als Photopolymerisationsinitiator ein Gemisch aus einem niedrig absorbierenden und einem stark absorbierenden Initiator enthält, wie sie weiter oben bereits beschrieben worden sind, während sie von den abrasiven Partikeln freie Lage der Schicht (S) nur einen oder mehrere niedrig absorbierende Initiatoren enthält. Vorzugsweise sind bei einer mehrlagigen Schicht (S) die Polymeren und photopolymerisierbaren niedermolekularen Verbindungen in den photopolymerisierbaren und/oder photovernetzbaren Materialien der einzelnen Lagen gleich oder zumindest ähnlich und miteinander verträglich.

Der dimensionsstabile Träger für die photopolymerisierbare und/oder photovernetzbare Schicht (S) ist im allgemeinen der eigentliche Druckformträger, es kann sich hierbei aber auch um einen temporären Träger handeln, der z.B. zur Lagerung und zum Transport der photopolymerisierbaren und/oder photovernetzbaren Schicht (S) dient und der dann nach Aufbringen der Schicht (S) auf den eigentlichen Druckformträger von der Schicht (S) abgezogen und entfernt wird. Bei den Druckformträgern handelt es sich im allgemeinen entweder um einen Stahlzylinder oder um ein plattenförmiges Stahlblech. Zur Erzielung einer guten Haftung zwischen der photopolymerisierbaren und/oder photovernetzbaren Schicht (S) und dem Druckformträger ist es oft zweckmäßig, den Druckformträger vor dem Aufbringen der Schicht (S) mit einer dünnen Schicht eines Haftvermittlers, beispielsweise auf Basis von Polyurethan-Reaktionslacken, Phenolharzen und/oder Epoxidharzen, zu versehen. Als Material für den temporären Träger kommen insbesondere dimensionsstabile Kunststoffolien einer Dicke im allgemeinen im Bereich von 50 bis 250 µm, insbesondere von 75 bis 150 µm in Betracht. Vorzugsweise besteht der temporäre Träger aus einer Polyester-Folie, insbesondere aus Polyethylenterephthalat oder Polybutylenterephthalat.

Die Herstellung der erfindungsgemäßen lichtempfindlichen Aufzeichnungsmaterialien erfolgt üblicherweise derart, daß zunächst die Bestandteile der photopolymerisierbaren und/oder photovernetzbaren Materialien innig miteinander vermischt werden und diese Mischung dann in Form der Schicht (S) auf den dimensionsstabilen Träger aufgebracht wird. Das Mischen der Bestandteile der photopolymerisierbaren und/oder photovernetzbaren Materialien kann dabei in an sich bekannter Weise in Lösung, einem Kneter oder jeder anderen Mischvorrichtung vorgenommen werden, die geeignet ist, eine innige Mischung und möglichst homogene Verteilung der einzelnen Bestandteile zu bewirken. Liegt die erhaltene Mischung in fester Form vor, kann anschließend die Schicht (S) durch Extrudieren, Kalandrieren oder Pressen des photopolymerisierbaren und/oder photovernetzbaren Materials geformt werden entweder unter gleichzeitigem oder anschließendem Auflaminieren oder Aufkaschieren auf den dimensionsstabilen Träger. Um in einfacher Weise die gewünschte glatte Oberfläche der Schicht (S) mit einer Rauhtiefe von <2 µm, vorzugsweise von <1 µm, zu erlangen, wird die Schicht (S) bevorzugt durch Gießen von einer Lösung des photopolymerisierbaren und/oder photovernetzbaren Materials auf den dimensionsstabilen Träger hergestellt. In diesem Fall wird selbstverständlich zweckmäßigerweise auch bereits das Mischen der Bestandteile des photopolymerisierbaren und/oder photovernetzbaren

Materials in Lösung durchgeführt. Als Lösungsmittel für die Gießlösungen, dessen Wahl auch von der Art und Zusammensetzung des photopolymerisierbaren und/oder photovernetzbaren Materials abhängt, kommen die hierfür üblichen und bekannten Lösungsmittel in Betracht, wie beispielsweise Alkohole, Ether, Ester, Ketone, aliphatische halogenierte Kohlenwasserstoffe, aromatische Kohlenwasserstoffe etc..

Vorteilhafterweise wird die photopolymerisierbare und/oder photovernetzbare Schicht (S) zunächst auf einen temporären Träger, insbesondere eine Polyester-Folie, aufgebracht und anschließend - entweder vor oder nach der Belichtung - auf den eigentlichen Druckformträger aufkaschiert. Diese Verfahrensweise hat sich insbesondere bei Einsatz von plattenförmigen Druckformträgern für die Herstellung von Druckplatten als günstig erwiesen. Hierbei wird in aller Regel die dem temporären Träger abgewandte Oberfläche der Schicht (S) auf den Druckformträger aufgebracht, so daß die dem temporären Träger zugewandte Oberfläche der Schicht (S) nachher die eigentliche Oberfläche der Druckform bildet.

Gegebenenfalls kann auf der Oberfläche der photopolymerisierbaren und/oder photovernetzbaren Schicht (S), die die spätere Oberfläche der eigentlichen Druckschicht der Tiefdruckform darstellt, noch eine dünne, bis etwa 5 µm dicke, vorzugsweise 1 bis 4 µm dicke, Schicht aufgebracht sein, die für aktinisches Licht durchlässig ist, die aber die Sauerstoffdiffusion in die photopolymerisierbare und/oder photovernetzbare Schicht (S) hemmt und somit eine Sauerstoffinhibierung der Photopolymerisation bei der Belichtung der erfindungsgemäßen lichtempfindlichen Aufzeichnungsmaterialien verhindert. Derartige Sauerstoff-Sperrschichten sind bei lichtempfindlichen Aufzeichnungsmaterialien für die Herstellung von Hochdruckformen oder Photoresists an sich bekannt und können im Fall der erfindungsgemäßen Aufzeichnungsmaterialien für die Herstellung von abrieb- und kratzfesten Tiefdruckformen aus den für die Sauerstoff-Sperrschichten üblichen und gebräuchlichen Materialien, insbesondere Kunststoffen, bestehen. Die Sauerstoff-Sperrschicht muß in dem Entwicklerlösungsmittel für die photopolymerisierbare und/oder photovernetzbare Schicht (S) löslich sein und wird nach dem Belichten der Aufzeichnungsmaterialien zusammen mit den unbelichteten Bereichen der Schicht (S) abgewaschen.

Weitere Einzelheiten über Aufbringen und Verarbeitung der photopolymerisierbaren Schichten können der EP-A- 0 070 511 entnommen werden.

Die photopolymerisierbaren und/oder photovernetzbaren Materialien für die Schicht (S) der erfindungsgemäßen lichtempfindlichen Aufzeichnungsmaterialien sollen so ausgewählt werden, daß die Druckschicht der daraus hergestellten Tiefdruckformen mindestens in dem die farbaufnehmenden Vertiefungen enthaltenden Schichtdickenbereich eine unter Last gemessene Vickers-Härte von mindestens 10 $N/mm^2$ hat. Im allgemeinen wird die Druckschicht über die gesamte Schichtdicke eine einheitliche Härte haben. Es ist aber auch möglich und hinreichend, wenn die Druckschicht nur in einem Oberflächenbereich bis zu einer Schichttiefe, die der Tiefe der farbaufnehmenden Näpfchen entspricht, die geforderte Härte aufweist, wobei die darunter liegenden Bereiche der Druckschicht beispielsweise weichelastisch ausgebildet sein können. Die Härte der Druckschicht wird dabei weniger durch Art und Menge der abrasiven Partikel beeinflußt, vielmehr hängt sie von dem in den photopolymerisierbaren und/oder photovernetzbaren Materialien eingesetzten Basispolymeren und dem Vernetzungsgrad bei der Photopolymerisation, d.h. von Art und Menge der Monomeren sowie von dem eingesetzten Photoinitiator ab. Wie das photopolymerisierbare und/oder photovernetzbare Material unter Berücksichtigung der hierzu oben gemachten Ausführungen beschaffen sein muß, damit es nach der Belichtung die gewünschte Härte besitzt, ist für den Fachmann durch wenige Vorversuche leicht zu ermitteln. Die Härte der Druckschicht oder auch von Schichtbereichen der Druckschicht, insbesondere dem Oberflächenbereich, kann gegebenenfalls durch Nachbehandlungsschritte bei der belichteten und entwickelten Druckform - wie sie nachfolgend näher beschrieben - variiert und noch vergrößert werden.

Die Auswahl der Materialien, insbesondere die Wahl des Basispolymeren für die photopolymerisierbaren und/oder photovernetzbaren Materialien wird auch durch den Anwendungsbereich der Tiefdruckformen insoweit mitbestimmt, als die Druckschicht gegenüber den für die Druckfarben verwendeten Lösungsmitteln resistent sein muß. Die am meisten verwendeten Lösungsmittel in Tiefdruckfarben sind Toluol und Alkohol, d.h. niedrig siedende aliphatische Kohlenwasserstoffe. Da die photopolymeren Druckschichten nicht gegen alle Lösungsmittel gleichermaßen resistent sind, hängt die Wahl des Basispolymeren in den photopolymerisierbaren und/oder photovernetzbaren Materialien auch von dem beim Tiefdruck zur Anwendung kommenden Druckfarbenlösungsmittel ab. Für die am meisten verbreiteten Druckfarben auf Basis von Toluol oder Alkohol als Lösungsmittel haben sich für die Herstellung der Tiefdruckformen insbesondere solche Materialien bewährt, die in der Schicht (S) als Basis-Polymer ein Polyamid oder Mischpolyamid bzw. ein Vinylalkoholpolymerisat oder teilverseiftes Vinylester-Polymerisat enthalten.

Zur Herstellung der Tiefdruckformen werden die erfindungsgemäßen lichtempfindlichen Aufzeichnungsmaterialien durch eine geeignete Bildvorlage mit aktinischem Licht bestrahlt, wodurch die belichteten Bereiche der Schicht (S) photopolymerisieren und vernetzen und so in der Entwicklerflüssigkeit unlöslich werden, während die unbelichteten Bereiche löslich bleiben und mit der Entwicklerflüssigkeit ausgewaschen werden können.

Wenn die photopolymerisierbare und/oder photovernetzbare Schicht (S) auf einem temporären Träger aufgebracht ist, so kann die Schicht (S) noch vor der Belichtung auf den Druckformträger aufkaschiert und anschließend belichtet werden. Die Belichtung kann danach wahlweise erfolgen, nachdem der temporäre Träger von der Schicht (S) abgezogen worden ist oder durch den temporären Träger hindurch, wobei dieser dann erst nach der Belichtung abgezogen wird. Andererseits ist es auch möglich, die auf dem temporären Träger befindliche photopolymerisierbare und/oder photovernetzbare Schicht (S) bereits vor dem Aufkaschieren auf den Druckformträger zu belichten.

Zum Belichten der lichtempfindlichen Aufzeichnungsmaterialien werden Lichtquellen eingesetzt, die aktinisches Licht im Wellenlängenbereich von im allgemeinen 250 bis 700 nm, vorzugsweise im Bereich von 300 bis 500 nm auszustrahlen vermögen und deren Emissionsmaxima im allgemeinen im Bereich der Absorption der Photoinitiatoren liegen. Für die erfindungsgemäße Herstellung der Tiefdruckformen können die in der Reproduktionstechnik üblichen Lichtquellen, wie Kohlebogenlampen, aktinische oder superaktinische Leuchtstoffröhren, Quecksilber-Nieder-, -Mittel- und -Hochdruckstrahler, die gegebenenfalls dotiert sein können, sowie Xenonlampen oder Laser mit hohem UV-Anteil, z.B. Argon-Ionen-Laser mit UV-Ausgangsleisten von 1 bis 2 Watt, verwendet werden. Der Belichtungsvorgang kann dabei in üblichen und gebräuchlichen Kontaktkopierrahmen (bei Platten oder Folien) oder auf handelsüblichen Rundbelichtungsgeräten (bei Zylindern) durchgeführt werden. Als Bildvorlage für die Belichtung können die üblichen Raster- oder Strich-Positive verwendet werden oder auch Halbton-Positive in Kombination mit Führungsraster-Vorlagen.

Die genaue Belichtungszeit hängt von der Art des für die photopolymerisierbare und/oder photovernetzbare Schicht (S) verwendeten Materials ab. Sie liegt üblicherweise im Bereich von 0,5 bis 10 Minuten und läßt sich für das verwendete Schichtmaterial durch wenige Vorversuche leicht ermitteln. Die Belichtungszeit soll dabei insbesondere so lang sein, daß die die abrasiven Partikel enthaltende Oberflächenzone der Schicht (S) vollständig durchpolymerisiert und vernetzt ist und beim anschließenden Auswaschvorgang von der Entwicklerflüssigkeit nicht mehr angegriffen wird. Das Auswaschen bzw. Entwickeln der bildmäßig belichteten Aufzeichnungsmaterialien zur Entfernung der unbelichteten und somit noch löslichen Schichtteile unter Ausbildung der Raster- und Näpfchenstruktur der Tiefdruckformen erfolgt in an sich bekannter und üblicher Weise durch Behandeln der bildmäßig belichteten Aufzeichnungsmaterialien mit der Entwicklerflüssigkeit, z.B. in einem Entwicklerflüssigbad, einem Sprühwascher oder Bürstenwascher oder auf sonst geeignete andere Weise.

Als Entwicklerflüssigkeiten bzw. Auswaschlösungsmittel kommen ausgewählt solche Lösungsmittel bzw. Lösungsmittelgemische in Frage, in welchen das unbelichtete photopolymerisierbare und/oder photovernetzbare Material gut löslich bzw. zumindest leicht dispergierbar ist, während die photopolymerisierten Materialien nach der Belichtung darin unlöslich bzw. nicht mehr dispergierbar sind. Die Wahl der geeigneten Entwicklerflüssigkeiten hängt von der Zusammensetzung des photopolymerisierbaren und/oder photovernetzbaren Materials, insbesondere von der Art des darin enthaltenen Polymeren ab. Vorzugsweise werden solche Entwicklerflüssigkeiten gewählt, die umwelt- und arbeitsfreundlich sind, d.h. die ohne besondere Vorsichtsmaßnahmen gehandhabt werden können und die einfach und leicht zu reinigen und aufzubereiten sind. Beispiele von Entwicklerflüssigkeiten sind niedere aliphatische Alkohole, Gemische von Alkoholen mit Wasser oder auch Wasser selber. Für photopolymerisierbare und/oder photovernetzbare Materialien auf Basis von Vinylalkoholpolymerisaten oder ungesättigten Polyesterharzen sind beispielsweise Wasser oder wäßrig-alkalische Lösungen als Entwicklerflüssigkeit geeignet; bei photopolymerisierbaren und/oder photovernetzbaren Materialien auf Basis von Mischpolyamiden haben sich als Entwicklerflüssigkeiten niedere aliphatische Alkohole, insbesondere Gemische von solchen Alkoholen mit Wasser, beispielsweise Mischungen aus Ethanol mit Wasser im Verhältnis 8:2 bewährt.

Das Behandeln der belichteten Tiefdruckformen mit Entwicklerflüssigkeit, d.h. den Vorgang des Auswaschens unbelichteter Teile, wird man bevorzugt bei Temperaturen durchführen, bei denen der Auswaschprozeß in einem möglichst kurzen Zeitraum, d.h. etwa innerhalb von 1 bis 10 Minuten beendet ist, ohne daß dabei jedoch die belichteten Bereiche der photopolymeren Tiefdruckformen durch die Entwicklerflüssigkeit angegriffen werden. Für die meisten Entwicklerflüssigkeiten sind Auswaschtemperaturen zwischen 10°C und 40°C vorteilhaft. Es ist ratsam, diese Lösungsmittelreste durch einen kurzzeitigen Trocknungsprozeß anschließend an den Auswaschvorgang zu entfernen. Die Trocknung kann bei Raumtemperatur oder auch bei höheren Temperaturen, beispielsweise im Bereich von 50°C bis 120°C, erfolgen. Die Trocknung bei erhöhter Temperatur bringt zusätzlich den Vorteil, daß hierdurch gegebenenfalls auch noch die Härte der Druckschicht erhöht werden kann.

In einigen Fällen, besonders bei den Tiefdruckformen, deren Druckschicht als Basispolymere Polyamide, Mischpolyamide oder Vinylalkoholpolymerisate enthalten, hat es sich als vorteilhaft herausgestellt, wenn die Tiefdruckformen nach der Trocknung durch kurzzeitiges Erwärmen auf Temperaturen im Bereich von 200°C

bis etwa 260°C, vorzugsweise auf Temperaturen von 220 bis 240°C einer zusätzlichen Härtung unterzogen wird. Für diese Nachhärtung bei hohen Temperaturen sind im allgemeinen Zeiten von 5 bis 60 Minuten ausreichend; es sind jedoch auch längere Zeiten für die Nachhärtung möglich. Bei diesem nachträglichen Härten wird die photopolymere Schicht eingebrannt, wobei ihre unter Last gemessene Vickers-Härte auf Werte über 200 $N/mm^2$ ansteigt. Eine gleichzeitige Verfärbung der Schicht nach hell- bis dunkelbraunen Farbtönen ist dabei sowohl bezüglich ihrer mechanischen als auch bezüglich ihrer drucktechnischen Eigenschaften unschädlich.

Ferner hat es sich in einigen Fällen als vorteilhaft erwiesen, die erfindungsgemäß hergestellte Tiefdruckform nach dem Auswaschen und Trocknen vollflächig nachzubelichten.

Die erfindungsgemäß hergestellten Tiefdruckformen eignen sich für den Einsatz in den konventionellen Tiefdruckmaschinen und liefern Druckergebnisse, die je nach der angewandten Technik und der Art des verwendeten photopolymerisierbaren und/oder photovernetzbaren Materials mit den Resultaten, die von herkömmlichen Tiefdruckformen erzielt werden, identisch sind. Ein wesentlicher Vorteil der erfindungsgemäß hergestellten Tiefdruckformen gegenüber den konventionellen Tiefdruckformen mit verchromten Kupferzylindern liegt in ihrer einfachen und schnellen Herstellmethode, ohne daß dabei die konventionellen Tiefdruckformen drucktechnische Vorteile aufweisen. Insbesondere zeichnen sich die erfindungsgemäß hergestellten Tiefdruckformen, gerade im Vergleich zu den bekannten Tiefdruckformen mit Kunststoffdruckschichten durch ihre hohe Abrieb- und Kratzfestigkeit aus, so daß es möglich ist, mit den erfindungsgemäß hergestellten Tiefdruckformen Auflagenhöhen von 500 000 bis 1 000 000 bei gleichbleibend guter Druckqualität, insbesondere auch hinsichtlich der Halbtonwiedergabe, zu erreichen. Besonders hervorzuheben ist ferner, daß beim Tiefdruck mit den erfindungsgemäß hergestellten Tiefdruckformen im Gegensatz zu den bisher bekannten Tiefdruckformen mit Kunststoff-Druckschichten die herkömmlichen gebräuchlichen Stahlrakel verwendet werden können, ohne daß hierdurch die Druckschicht oder die Stahlrakel in irgendeiner Weise beschädigt werden. Die Stahlrakel schleifen sich bei Einsatz der erfindungsgemäß hergestellten Tiefdruckformen in gleicher Weise wie bei den konventionellen Tiefdruckformen gleichmäßig an der Oberfläche der photopolymeren Druckschicht ab. Als besonders vorteilhaft haben sich beim Tiefdruck mit den erfindungsgemäß hergestellten Tiefdruckformen biegeelastische Stahlrakel mit abgerundeten Fasenkanten und einer Oberflächenhärte von mindestens 350 (Vickers-Härte nach DIN 50 133) erwiesen, wie sie in der DE-A 31 10 842 beschrieben sind. Sofern die erfindungsgemäß hergestellten Tiefdruckformen bei ihrer Verwendung, beispielsweise durch fehlerhafte Rakel oder dergleichen, beschädigt werden und Kratzer, Rillen oder Riefen aufweisen, lassen sie sich in gleicher Weise wie die herkömmlichen Tiefdruckformen glatt polieren.

Die Erfindung wird durch die nachfolgenden Beispiele erläutert. Die in den Beispielen angegebenen Teile beziehen sich, sofern nicht anders angegeben, auf das Gewicht.

Die Messung der Klischeehärte erfolgt mittels einer Apparatur zur Bestimmung der Brinellhärte (siehe DIN 53456) unter Belastung durch Ausmessen der Eindringtiefe einer Quarzkugel mit einem Durchmesser von 5.926 mm.

Zur Prüfung der Kratzfestigkeit wird die Probe auf einen drehbaren Teller gespannt und unter verschiedener Belastung der Beanspruchung durch einen kegelförmigen Diamantstichel (90° Kegelwinkel und 90 µm Spitzenradius) ausgesetzt. Die belastende Kraft wird so lange gesteigert, bis mit dem unbewaffneten Auge Spuren sichtbar werden. Die so erhaltenen Kratzer werden vermessen. Als Maß für die Kratzfestigkeit wird die Kraft definiert, die zur Erzeugung eines mit einem Oberflächenmeßgerät (z.B. Perthometer der Firma Perthen) gerade detektierbaren Kratzers führt; ein solcher Kratzer ist etwa 0,5 µm tief.

Beispiel 1

Eine 200 µm dicke photopolymerisierbare Schicht, bestehend aus 54 Teilen eines partiell hydrolysierten Polyvinylacetats (Verseifungsgrad 88%), das mit 3% Methacrylsäure verestert wurde, 36 Teilen eines aliphatischen Epoxidacrylats gemäß Formel (I) mit

$$R^2=R^{2'}= -OH \text{ und}$$

$R^3=R^{3'}=$ 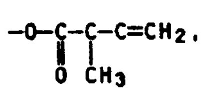

10 Teilen mit Aminosilan behandeltem Quarzmehl (mit 95% der Teilchen feiner als 5 µm und 50% der Teilchen feiner als 2 µm; z.B. Silbond® 800 AST der Firma Quarzwerke Frechen), 1,5 Teilen Benzildimethylketal, 0,5 Teilen Kaliumsalz des N-Nitrosocyclohexylhydroxylamins und 0,05 Teilen Safranin T (C.I. 50240) wird auf ein

mit einer Haftschicht versehenes Stahlblech aufgebracht. Nach Belichten, Auswaschen in Wasser und Trocknen beträgt die Kugeleindruckhärte 126 N/mm². Ein erster Kratzer wird bei einer Belastung von 1,2 N sichtbar. Mit einer Belastung von 2,1 N läßt sich ein Kratzer von 1 µm Tiefe erzeugen.

Vergleichsbeispiel 1

Ersetzt man in der in Beispiel 1 beschriebenen Mischung das Epoxidacrylat gemäß Formel (I) durch ein aliphatisches Diacrylat, z.B. Dicyclopentenyldiacrylat als Monomeres, so erhält man nach der Behandlung eine Platte mit einer Kugeleindruckhärte von 118 N/mm². Ein erster Kratzer wird bei 0.67 N sichtbar. Bei einer Belastung von 2.1 N ist der Kratzer 4 µm tief.

Beispiel 2

Eine photopolymerisierbare Mischung wie unter Beispiel 1 beschrieben, wobei als Monomerkomponente das Produkt der Umsetzung von 3,4-Epoxycyclohexylmethyl-3′,4′-epoxycyclohexancarboxylat mit Methacrylsäure im molaren Verhältnis 1:2.2 eingesetzt wird, wird in gleicher Weise belichtet, mit Wasser ausgewaschen, getrocknet und nachbelichtet. Die Härte der Platte beträgt 127 N/mm². Ein erster Kratzer tritt bei einer Belastung von 1.67 N auf. Eine Kraft von 2.1 N hinterläßt einen Kratzer von 1 µm Tiefe.

Beispiel 3

Aus einer Lösung von 58 Teilen eines in wäßrigem Alkohol löslichen Mischpolyamids aus etwa gleichen Teilen Hexamethylendiamin-Adipat, 4,4′-Diamino-dicyclohexylmethan-adipat und ε-Caprolactam, 30 Teilen eines Monomeren gemäß der allgemeinen Formel (I), mit je einem der Reste $R^2$ oder $R^3$ und $R^{2'}$ oder $R^{3'}$ als OH und dem verbleibenden als

$$-O-\underset{\underset{O}{\|}}{C}-CR^6=CH_2 \text{ mit } R^6=H \text{ ,}$$

10 Teilen des in Beispiel 1 angeführten Quarzmehls, 1,2 Teilen Benzildimethylketal, 0,6 Teilen Kaliumsalz des N-Nitrosocyclohexylhydroxylamins und 0,04 Teilen Safranin T wird eine Druckplatte durch Aufbringen der Masse auf einen formstabilen Träger mit 100 bis 200 µm Schichtdicke hergestellt. Nach bildmäßigem Belichten, Entwickeln in wäßrigem Alkohol, Trocknen und Nachbelichten erhält man ein Klischee mit gut ausgebildetem Relief und glatter Oberfläche. Die Brinellhärte beträgt 40 N/mm², ein Kratzer kann erst mit einer Kraft von mindestens 0,9 N/mm² erzeugt werden. Bei Belastung mit 2,1 N entsteht ein Kratzer von 3 µm Tiefe.

Beispiel 4

Es wird wie in Beispiel 3 vorgegangen, als Monomerkomponenten jedoch eine 1:1 Mischung aus dem entsprechenden Acrylat ($R^6$=H) und Methacrylat ($R^6=CH_3$) eingesetzt. Die Brinellhärte beträgt 25 N/mm², ein erster Kratzer wird mit 0,6 N erzeugt. Bei einer Belastung mit 2,1 N entsteht ein Kratzer mit 4 µm Tiefe.

Vergleichsbeispiel 2

Eine photopolymerisierbare Mischung, bestehend aus 58 Teilen eines Mischpolyamids wie oben beschrieben, 30 Teilen eines linearen, gesättigten Triacrylats, 10 Teilen Quarzmehl, 1,5 Teilen Benzildimethylketal, 0,3 Teilen Kaliumsalz des N-Nitrosocyclohexylhydroxylamins und 0,03 Teilen Safranin T wird durch Aufbringen einer 200 µm Schicht auf einen formstabilen Träger zu einer Druckplatte geformt, belichtet, in wäßrigem Alkohol ausgewaschen, getrocknet und nachbelichtet. Das so erhaltene Klischee hat eine Brinellhärte von 24 N/mm². Mit einer Kraft von 0.4 N läßt sich ein 1 µm tiefer Kratzer erzeugen. Bei Belastung mit 2.1 N entsteht ein Kratzer von 7 µm Tiefe.

Beispiel 5

Es wird wie in Beispiel 1 verfahren, wobei das Monomere nach Formel (I) zu 15% durch Polyethylenglykol-400-dimethacrylat (Hersteller: Fa. Röhm) ersetzt wird.

Die Kugeleindruckhärte einer aus solcher Rezeptur hergestellten Tiefdruckplatte beträgt 113 $N/mm^2$. Ein erster Kratzer wird bei einer Belastung von 0,7 N sichtbar. Belastung mit 2,1 N erzeugt einen Kratzer von 1,5 μm.

## Patentansprüche

1. Lichtempfindliches Aufzeichnungsmaterial für die Herstellung von Tiefdruckplatten mit einer auf einem dimensionsstabilen Träger aufgebrachten 30 bis 500 μm dicken Schicht (S) eines in einer Entwicklerflüssigkeit löslichen bzw. dispergierbaren und durch Belichtung mit aktinischem Licht in dieser Entwicklerflüssigkeit unlöslich bzw. nicht mehr dispergierbar werdenden photopolymerisierbaren und/oder photovernetzbaren Materials, wobei das photopolymerisierbare und/oder photovernetzbare Material zumindest in einer Oberflächenzone von 1 bis 50 μm der Oberfläche der Schicht (S), die die spätere Oberfläche der Druckform bildet, feinteilige, abrasive Partikel in einer solchen Menge enthält, daß diese 2 bis 50 Gew.% des diese Partikel enthaltenden photopolymerisierbaren und/oder photovernetzbaren Materials betragen, wobei die mittlere Teilchengröße der abrasiven Partikel im Bereich von 0,1 bis 6 μm liegt, höchstens 5 % der abrasiven Partikel Längsausdehnungen größer 10 μm aufweisen und die abrasiven Partikel eine Härte von >4,0 auf der Mohs'schen Härteskala besitzen, die Oberfläche der Schicht (S), die die spätere Oberfläche der Druckform bildet, eine Rauhtiefe von < 2 μm besitzt und die Bestandteile des photopolymerisierbaren und/oder photovernetzbaren Materials der Schicht (S) so gewählt werden, daß diese Schicht nach der Belichtung, Entwicklung und Trocknung mindestens in dem die farbaufnehmenden Vertiefungen enthaltenden Schichtdickenbereich eine unter Last gemessene Härte von mindestens 10 $N/mm^2$ besitzt, dadurch gekennzeichnet, daß in dem photovernetzbaren und/oder photopolymerisierbaren Material mindestens ein Cyclohexanderivat gemäß der allgemeinen Formel (I)

   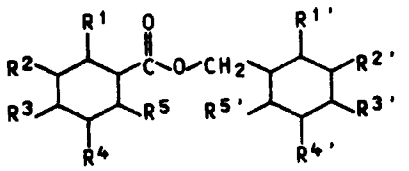

   (I),

   worin mindestens einer der Reste $R^1$ bis $R^5$ und $R^{1'}$ bis $R^{5'}$, jedoch nicht mehr als zwei der Reste $R^1$ bis $R^5$ und nicht mehr als zwei der Reste $R^{1'}$ bis $R^{5'}$ für die Gruppierung

   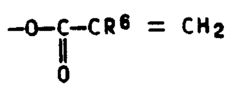 mit $R^6$ = H oder $CH_3$

   stehen, mindestens einer der Reste $R^1$ bis $R^5$ und $R^{1'}$ bis $R^{5'}$, jedoch nicht mehr als zwei der Reste $R^1$ bis $R^5$ und nicht mehr als zwei der Reste $R^{1'}$ bis $R^{5'}$ für OH-Gruppen stehen und die noch verbleibenden Reste $R^1$ bis $R^5$ und $R^{1'}$ bis $R^{5'}$ für H oder $CH_3$ stehen, enthalten ist.

2. Aufzeichnungsmaterial nach Anspruch 1, dadurch gekennzeichnet, daß Hydroxylgruppe und

   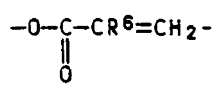-Gruppe

   jeweils an benachbarten Kohlenstoffatomen stehen.

3. Aufzeichnungsmaterial nach Anspruch 1 oder 2, dadurch gekennzeichnet, daß jeweils einer der

OH- oder 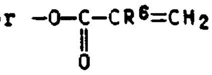 -Reste

in para-Stellung zu dem C-Atom des Cyclohexanrings steht, über das die beiden Cyclohexanringe über die

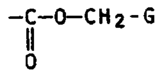 -Gruppe

miteinander verbunden sind.

4. Aufzeichnungsmaterial nach Anspruch 1 oder 2, dadurch gekennzeichnet, daß als Verbindung der allgemeinen Formel (I) ein Umsetzungsprodukt des 3,4-Epoxycyclohexylmethyl-3′,4′-epoxycyclohexancarboxylats mit Acrylsäure oder Methacrylsäure im molaren Verhältnis von 1:1 bis 1:2,5 eingesetzt wird.

5. Aufzeichnungsmaterial nach einem der vorhergehenden Ansprüche, dadurch gekennzeichnet, daß bis zu 60 Gew.% der Verbindung der allgemeinen Formel (I) teilweise durch eine oder mehrere weitere photopolymerisierbare und/oder photovernetzbare Verbindungen ersetzt ist.

6. Aufzeichnungsmaterial nach einem der vorhergehenden Ansprüche, dadurch gekennzeichnet, daß als photopolymerisierbares und/oder photovernetzbares Material ein Gemisch einer Verbindung der allgemeinen Formel (I) mit einem teilverseiften Polyvinylacetat, dessen Hydroxylgruppen teilweise mit Acrylsäure oder Methacrylsäure verestert ist, eingesetzt wird.

7. Verfahren zur Herstellung von Tiefdruckformen durch Belichten eines lichtempfindlichen Aufzeichnungsmaterials mit einer photopolymerisierbaren und/oder photovernetzbaren Schicht (S) auf einem dimensionsstabilen Träger mit aktinischem Licht durch ein Raster- oder Strich-Positiv oder durch ein Halbton-Positiv und eine Führungsraster-Vorlage, anschließendes Auswaschen der nicht belichteten Anteile der Schicht (S) mit Hilfe einer Entwicklerflüssigkeit, in der die nicht belichteten Anteile, nicht aber die belichteten Anteile der Schicht (S) löslich oder dispergierbar sind, sowie Trocknen und gegebenenfalls Nachbehandlung der erhaltenen Tiefdruckform, dadurch gekennzeichnet, daß man zur Herstellung der Tiefdruckformen ein lichtempfindliches Aufzeichnungsmaterial gemäß einem der Ansprüche 1 bis 6 einsetzt.

8. Verfahren zur Herstellung von Tiefdruckformen gemäß Anspruch 7, dadurch gekennzeichnet, daß die Tiefdruckformen nach dem Auswaschen und Trocknen vollflächig mit aktinischem Licht nachbelichtet werden.

9. Verfahren zur Herstellung von Tiefdruckformen gemäß den Ansprüchen 7 oder 8, dadurch gekennzeichnet, daß die Tiefdruckformen nach dem Auswaschen der unbelichteten Anteile und Trocknen bei einer Temperatur im Bereich von 200°C bis 260°C nachgehärtet werden.

## Claims

1. A light-sensitive recording material for the production of intaglio printing plates, comprising on a dimensionally stable base material a layer (L) from 30 to 500 μm thick of a photopolymerizable and/or photocrosslinkable material which is soluble or dispersible in a developer liquid and which, on exposure to actinic light, is rendered insoluble or no longer dispersible in the developer liquid and which, at least in a surface zone of from 1 to 50 μm of the surface of the layer (L) which forms the later surface of the printing plate, contains finely divided abrasive particles in such an amount that they account for from 2 to 50 % by weight of the photopolymerizable and/or photocrosslinkable material containing these particles, the average particle size of the abrasive particles being within the range from 0.1 to 6 μm, not more than 5 % of the abrasive particles having longitudinal dimensions greater than 10 μm and the abrasive particles having a hardness of >4.0 on the Mohs hardness scale, the surface of the layer (L) which forms the later surface of the printing plate having a peak-to-valley height of <2 μm and the constituents of the photopolymerizable and/or photocrosslinkable material of the layer (L) being chosen in such a way that this layer has after exposure, development and drying a hardness, measured under load, of not less than 10 N/mm$^2$ at least in the layer thickness range containing the ink-receiving recesses, wherein the photocrosslinkable and/or photopolymerizable material contains one or more derivatives of the general formula (I)

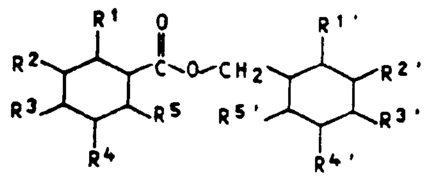 (I),

where one or more of the radicals $R^1$ to $R^5$ and $R^{1'}$ to $R^{5'}$ but no more than two of the radicals $R^1$ to $R^5$ and no more than two of the radicals $R^{1'}$ to $R^{5'}$ are each a group -O-C(O)-$CR^6$=$CH_2$ where $R^6$ is H or $CH_3$, one or more of the radicals $R^1$ to $R^5$ and $R^{1'}$ to $R^{5'}$ but no more than two of the radicals $R^1$ to $R^5$ and no more than two of the radicals $R^{1'}$ to $R^{5'}$ are each OH and the remaining radicals $R^1$ to $R^5$ and $R^{1'}$ to $R^{5'}$ are each H or $CH_3$.

2. A recording material as claimed in claim 1, wherein hydroxyl and

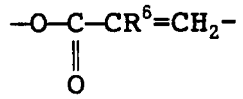

are each on adjacent carbon atoms.

3. A recording material as claimed in claim 1 or 2, wherein one each of

OH or 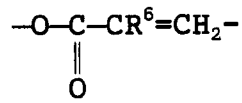

is para to the carbon atom of the cyclohexane ring via which the two cyclohexane rings are linked to one another via the

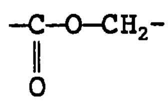

group.

4. A recording material as claimed in claim 1 or 2, wherein the compound of the general formula (I) is a reaction product of 3,4-epoxycyclohexylmethyl 3′,4′-epoxycyclohexanecarboxylate with acrylic acid or methacrylic acid in a molar ratio of from 1:1 to 1:2.5.

5. A recording material as claimed in any of the preceding claims, wherein up to 60% by weight of the compound of the general formula (I) has been partly replaced by one or more further photopolymerizable or photocrosslinkable compounds.

6. A recording material as claimed in any of the preceding claims, wherein the photopolymerizable or photocrosslinkable material used is a mixture of a compound of the general formula (I) with a partially hydrolyzed polyvinyl acetate whose hydroxyl groups have been partly esterified with acrylic acid or methacrylic acid.

7. A process for producing an intaglio printing plate by exposing a light-sensitive recording material comprising a photopolymerizable and/or photocrosslinkable layer (L) on a dimensionally stable base to actinic light

through a halftone or line positive or through a continuous tone positive and a screen grid, subsequent washout of the unexposed areas of the layer (L) by means of a developer liquid in which the unexposed areas but not the exposed areas of the layer (L) are soluble or dispersible, and drying with or without aftertreatment of the intaglio printing plate obtained, which comprises using for the production of the intaglio printing plate a light-sensitive recording material as claimed in any of claims 1 to 6.

8. A process for producing an intaglio printing plate as claimed in claim 7, wherein the intaglio printing plate, after washout and drying, is subjected to a uniform after-exposure under actinic light.

9. A process for producing an intaglio printing plate as claimed in claim 7 or 8, wherein the intaglio printing plate, after washout of the unexposed areas and drying, is postcured at within the range from 200°C to 260°C.

## Revendications

1. Matériau d'enregistrement photosensible pour la fabrication de plaques d'impression en creux, comprenant, appliquée sur un support à dimensions stables, une couche (S), épaisse de 30 à 500 µm, d'une matière photopolymérisable et/ou photoréticulable soluble ou dispersable dans un liquide révélateur mais rendue insoluble ou non dispersable dans ce liquide révélateur par l'exposition à la lumière actinique, la matière photopolymérisable et/ou photoréticulable contenant, au moins dans une zone de surface de 1 à 50 um de la surface supérieur de la couche (S) qui forme ultérieurement la surface de la forme d'impression, des fines particules abrasives en quantité représentant de 2 à 50 % du poids de la matière photopolymérisable et/ou photoréticulable contenant ces particules, la dimension moyenne des particules abrasives se situant dans l'intervalle de 0,1 à 6 µm, 5 % au maximum des particules abrasives ayant des dimensions longitudinales supérieures à 10 µm et les particules abrasives ayant une dureté supérieure à 4,0 sur l'échelle des duretés de Mohs, la surface de la couche (S) formant ultérieurement la surface de la forme d'impression ayant une profondeur de rugosité inférieure à 2 µm et les constituants de la matière photopolymérisable et/ou photoréticulable de la couche (S) étant choisis en sorte que cette couche, après exposition à la lumière, développement et séchage, ait, au moins dans la région de l'épaisseur de la couche contenant les creux récepteurs d'encre, une dureté mesurée sous charge d'au moins 10 N/mm$^2$, caractérisé en ce que la matière photoréticulable et/ou photopolymérisable contient au moins un dérivé du cyclohexane de formule générale I

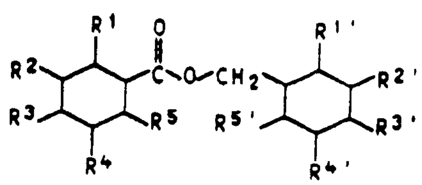

(I),

dans laquelle au moins un des symboles $R^1$ à $R^5$ et $R^{1'}$ à $R^{5'}$ mais pas plus de deux des symboles $R^1$ à $R^5$ et pas plus de deux des symboles $R^{1'}$ à $R^{5'}$, représentent le groupement

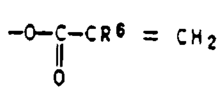

avec $R^6$ = H ou $CH_3$

au moins un des symboles $R^1$ à $R^5$ et $R^{1'}$ à $R^{5'}$ mais pas plus de deux des symboles $R^1$ à $R^5$ et pas plus de deux des symboles $R^{1'}$ à $R^{5'}$ représentent des groupes OH, et les autres symboles $R^1$ à $R^5$ et $R^{1'}$ à $R^{5'}$ représentent H ou $CH_3$.

2. Matériau d'enregistrement selon la revendication 1, caractérisé en ce qu'un groupe hydroxy et un groupe

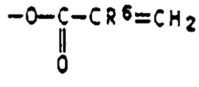

sont situés sur des atomes de carbone voisins.

3. Matériau d'enregistrement selon la revendication 1 ou 2, caractérisé en ce qu'il y a un groupe OH ou un groupe

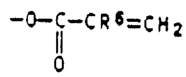

en position para de l'atome de carbone du noyau cyclohexane par l'intermédiaire duquel, et par le groupe

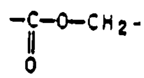

les deux noyaux cyclohexane sont reliés entre eux.

4. Matériau d'enregistrement selon la revendication 1 ou 2, caractérisé en ce que l'on utilise en tant que composé de formule générale I un produit de réaction du 3′-4′-époxycyclohexane-carboxylate de 3,4-époxycyclohexylméthyle avec l'acide acrylique ou méthacrylique dans un rapport molaire de 1:1 à 1:2,5.

5. Matériau d'enregistrement selon l'une des revendications qui précèdent, caractérisé en ce que l'on remplace jusqu'à 60 % du poids du composé de formule générale I par un ou plusieurs autres composés photopolymérisables et/ou photoréticulables.

6. Matériau d'enregistrement selon l'une des revendications qui précèdent, caractérisé en ce que l'on utilise en tant que matière photopolymérisable et/ou photoréticulable un mélange d'un composé de formule générale I avec un polyacétate de vinyle partiellement saponifié dont les groupes hydroxy sont partiellement estérifiés par l'acide acrylique ou méthacrylique.

7. Procédé pour la fabrication de formes d'impression en creux par exposition à la lumière actinique d'un matériau d'enregistrement photosensible comprenant une couche photopolymérisable et/ou photoréticulable (S) appliquée sur un support à dimensions stables au travers d'un positif à réseau ou à lignes ou au travers d'un positif en demiton et d'un modèle de réseau de guidage en faisant suivre d'un lavage des régions non exposées de la couche (S) par un liquide révélateur dans lequel les régions non exposées et non les régions exposées de la couche (S) sont solubles ou dispersables, puis d'un séchage et le cas échéant d'un traitement complémentaire de la forme d'impression en creux ainsi obtenue, caractérisé en ce que, pour la fabrication de la forme d'impression en creux, on utilise un matériau d'enregistrement photosensible selon l'une des revendications 1 à 6.

8. Procédé pour la fabrication de formes d'impression en creux selon la revendication 7, caractérisé en ce que, après lavage et séchage, les formes d'impression en creux sont réexposées à la lumière actinique sur toute la surface.

9. Procédé pour la fabrication de formes d'impression en creux selon les revendications 7 ou 8, caractérisé en ce que les formes d'impression en creux, après lavage des parties non exposées et séchage, sont soumises à durcissement complémentaire à une température dans l'intervalle de 200 à 260 degrés C.